(19) Europäisches Patentamt
European Patent Office
Office européen des brevets

(11) EP 2 720 085 A1

(12) **EUROPEAN PATENT APPLICATION**

(43) Date of publication:
**16.04.2014 Bulletin 2014/16**

(51) Int Cl.:
*G03F 7/027* (2006.01) *G03F 7/075* (2006.01)

(21) Application number: **13178450.6**

(22) Date of filing: **30.07.2013**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **11.10.2012 KR 20120113152**

(71) Applicant: **CHEIL INDUSTRIES INC.**
**Gumi-si,**
**Gyeongsangbuk-do 730-710 (KR)**

(72) Inventors:
- **Nam, Seong Ryong**
  **Uiwang-si, Gyeonggi-do (KR)**
- **Lee, Chang Min**
  **Uiwang-si, Gyeonggi-do (KR)**
- **Choi, Seung Jib**
  **Uiwang-si, Gyeonggi-do (KR)**
- **Kwon, Ji Hye**
  **Uiwang-si, Gyeonggi-do (KR)**
- **Woo, Chang Soo**
  **Uiwang-si, Gyeonggi-do (KR)**
- **Lee, Yeon Soo**
  **Uiwang-si, Gyeonggi-do (KR)**
- **Ha, Kyoung Jin**
  **Uiwang-si, Gyeonggi-do (KR)**

(74) Representative: **Michalski Hüttermann & Partner**
**Patentanwälte**
**Speditionstraße 21**
**40221 Düsseldorf (DE)**

(54) **Photocurable composition and encapsulated apparatus including barrier layer formed of the same**

(57) The present invention relates to a photocurable composition and an organic light emitting display apparatus including a barrier layer formed of the photocurable composition. The photocurable composition includes (A) a photocurable monomer, (B) a silicon-containing monomer, and (C) a photopolymerization initiator, wherein the (B) silicon-containing monomer has a structure represented by Formula 1.

**Fig 1.**

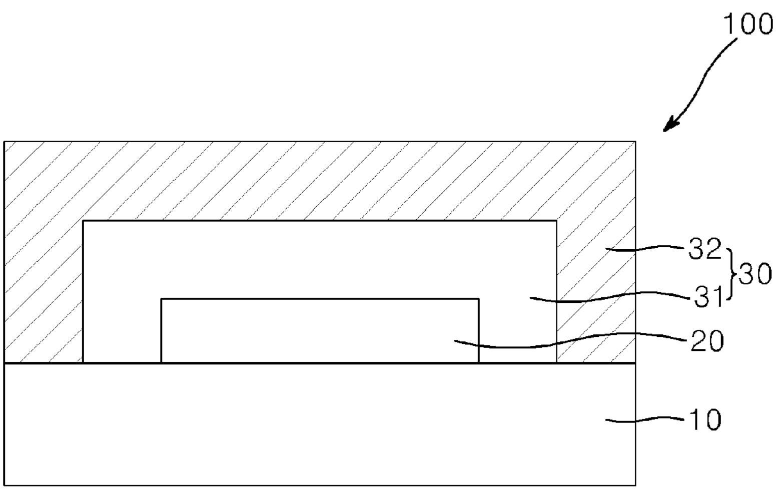


EP 2 720 085 A1

## Description

### Field of the Invention

The present invention relates to a photocurable composition and an encapsulated apparatus including a barrier layer formed of the same.

### Description of the Related Art

Organic light emitting diodes (OLEDs) refer to a structure in which a functional organic material layer is inserted between an anode and a cathode, wherein an exciton having high energy can be created by recombination of a hole injected into the cathode and an electron injected into the anode. The created exciton may move back to a ground state, thereby emitting light within a specific wavelength band. Organic light emitting diodes have various merits such as self-luminance, fast response time, wide viewing angle, ultra-thinness, high definition and durability.

However, organic light emitting diodes have problems in that due to moisture or oxygen flowing from outside or due to outgassing inside or outside the light emitting diodes despite sealing, organic materials and/or electrode materials can be oxidized, causing deterioration in the performance and lifespan thereof. In order to overcome such problems, some methods have been proposed, such as coating with a photocurable sealing agent, attachment of a transparent or opaque moisture absorbent, or provision of frits to a substrate on which an organic light emitting part is formed.

For instance, Korean Publication No. 2006-0084978A discloses an encapsulated structure of organic light emitting diode devices, which includes a protective membrane for encapsulation formed of a moisture penetration inhibiting silicone compound or polymer resin.

### Summary of the Invention

In one embodiment of the present invention, a photocurable composition may include: (A) a photocurable monomer; (B) a silicon-containing monomer; and (C) a photopolymerization initiator, wherein the (B) silicon-containing monomer may have a structure represented by Formula 1:

[Formula 1]

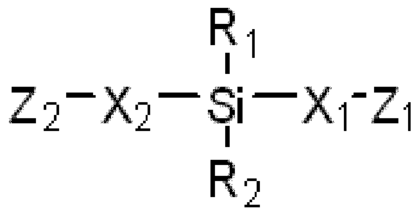

,

wherein $R_1$, $R_2$, $X_1$, $X_2$, $Z_1$ and $Z_2$ are defined as set forth in the following detailed description.

In another embodiment of the present invention, an encapsulated apparatus may include a member for the apparatus and a barrier stack formed on the member for the apparatus and including an inorganic barrier layer and an organic barrier layer formed from the photocurable composition, wherein the organic barrier layer may have an outgas generation amount of ≤ 1,000 ppm.

In another embodiment of the present invention, an encapsulated apparatus may include a member for the apparatus and a barrier stack formed on the member for the apparatus and including an inorganic barrier layer and an organic barrier layer formed from the photocurable composition, wherein the organic barrier layer may have a water vapor transmission rate of ≤ 5.0 g/$m^2$ · 24hr, as measured at 37.8°C and 100% relative humidity (RH) for 24 hours at a layer thickness of the organic barrier layer of 5 μm.

### Brief Description of Drawings

Fig. 1 is a sectional view of an encapsulated apparatus according to one embodiment of the present invention.
Fig. 2 is a sectional view of an encapsulated apparatus according to another embodiment of the present invention.

**Detailed description of the Invention**

Unless otherwise stated, the term "substituted" as used herein means that at least one hydrogen atom among functional groups of the present invention is substituted with a halogen (F, Cl, Br or I), a hydroxyl group, a nitro group, a cyano group, an imino group (=NH, =NR, wherein R is a $C_1$ to $C_{10}$ alkyl group), an amino group [$-NH_2$, -NH(R'), -N(R")(R"'), wherein R', R" and R"' are each independently a $C_1$ to $C_{10}$ alkyl group], an amidino group, a hydrazine or hydrazone group, a carboxyl group, a substituted or unsubstituted $C_1$ to $C_{20}$ alkyl group, a substituted or unsubstituted $C_6$ to $C_{30}$ aryl group, a substituted or unsubstituted $C_3$ to $C_{30}$ cycloalkyl group, a substituted or unsubstituted $C_3$ to $C_{30}$ heteroaryl group, or a substituted or unsubstituted $C_2$ to $C_{30}$ heterocycloalkyl group.

The term "hetero" as used herein means that a carbon atom is substituted with an atom selected from the group consisting of N, O, S and P.

One embodiment of the present invention relates to a photocurable composition including: (A) a photocurable monomer; (B) a silicon-containing monomer; and (C) a photopolymerization initiator.

(A) Photocurable monomer

The photocurable monomer may refer to a non-silicon type photocurable monomer which does not contain silicon and has one or more photocurable functional groups, for example, a (meth)acrylate group, a vinyl group, and the like.

The photocurable monomer may include a monofunctional monomer having an unsaturated group, a polyfunctional monomer having an unsaturated group, and mixtures thereof. The photocurable monomer may include monomers having $\geq 1$ to $\leq 30$, preferably $\geq 1$ to $\leq 20$, more preferably $\geq 1$ to $\leq 6$ photocurable functional groups. The photocurable functional group may include a substituted or unsubstituted vinyl group, a substituted or unsubstituted acrylate group, or a substituted or unsubstituted methacrylate group.

The photocurable monomer may include a mixture of the monofunctional monomer and the polyfunctional monomer. In the mixture, the monofunctional monomer and the polyfunctional monomer may be present in a weight ratio from 1:0.1 to 1:10, for example from 1:2 to 1:3.75(the monofunctional monomer : the polyfunctional monomer).

Examples of the photocurable monomer may include a $C_6$ to $C_{20}$ aromatic compound having a substituted or unsubstituted vinyl group; an unsaturated carboxylic acid ester having a $C_1$ to $C_{20}$ alkyl group, a $C_3$ to $C_{20}$ cycloalkyl group, a $C_6$ to $C_{20}$ aromatic group, or a $C_1$ to $C_{20}$ alkyl group having a hydroxyl group; an unsaturated carboxylic acid ester having a $C_1$ to $C_{20}$ amino alkyl group; a vinyl ester of a $C_1$ to $C_{20}$ saturated or unsaturated carboxylic acid; a $C_1$ to $C_{20}$ unsaturated carboxylic acid glycidyl ester; a vinyl cyanide compound; an unsaturated amide compound; a (meth)acrylate of a monoalcohol or a polyhydric alcohol; or mixtures thereof.

Particularly, examples of the photocurable monomer may include a $C_6$ to $C_{20}$ aromatic compound having an alkenyl group including a vinyl group such as styrene, $\alpha$-methyl styrene, vinyl toluene, vinyl benzyl ether, vinyl benzyl methyl ether, and the like; an unsaturated carboxylic acid ester such as methyl (meth)acrylate, ethyl (meth)acrylate, butyl (meth)acrylate, 2-hydroxyethyl (meth)acrylate, 2-hydroxybutyl (meth)acrylate, hexyl (meth)acrylate, octyl (meth)acrylate, nonyl (meth)acrylate, decanyl (meth)acrylate, undecanyl (meth)acrylate, dodecyl (meth)acrylate, cyclohexyl (meth)acrylate, benzyl (meth)acrylate, phenyl (meth)acrylate, and the like; an unsaturated carboxylic acid amino alkyl ester such as 2-aminoethyl (meth)acrylate, 2-dimethylaminoethyl (meth)acrylate, and the like; a saturated or unsaturated carboxylic acid vinyl ester such as vinyl acetate, vinyl benzoate, and the like; a $C_1$ to $C_{20}$ unsaturated carboxylic acid glycidyl ester such as glycidyl acrylate, glycidyl (meth)acrylate, and the like; a vinyl cyanide compound such as acrylonitrile, (meth)acrylonitrile, and the like; an unsaturated amide compound such as acrylamide, (meth)acrylamide, and the like; a monofunctional or polyfunctional (meth)acrylate of a monoalcohol or polyhydric alcohol such as ethylene glycol di(meth)acrylate, triethylene glycol di(meth)acrylate, trimethylolpropane tri(meth)acrylate, 1,4-butanediol di(meth)acrylate, 1,6-hexanediol di(meth)acrylate, octanediol di(meth)acrylate, nonanediol di(meth)acrylate, decanediol di(meth)acrylate, undecanediol di(meth)acrylate, dodecanediol di(meth)acrylate, neopentylglycol di(meth)acrylate, pentaerythritol di(meth)acrylate, pentaerythritol tri(meth)acrylate, pentaerythritol tetra(meth)acrylate, dipentaerythritol di(meth)acrylate, dipentaerythritol tri(meth)acrylate, dipentaerythritol penta(meth)acrylate, dipentaerythritol hexa(meth)acrylate, bisphenol A di(meth)acrylate, novolac epoxy (meth)acrylate, diethyleneglycol di(meth)acrylate, tri(propylene glycol) di(meth)acrylate, poly(propylene glycol) di(meth)acrylate, and the like, without being limited thereto. The 'polyhydric alcohol' refers to an alcohol having two or more, $\geq 2$ to $\leq 20$, preferably $\geq 2$ to $\leq 10$, more preferably $\geq 2$ to $\leq 6$ hydroxyl groups.

Preferably, the photocurable monomer may include at least one of a (meth)acrylate having a $C_1$ to $C_{20}$ alkyl group, a di(meth)acrylate of a $C_2$ to $C_{20}$ diol, a tri(meth)acrylate of a $C_3$ to $C_{20}$ triol, and a tetra(meth)acrylate of a $C_4$ to $C_{20}$ tetraol.

The photocurable monomer may be present in an amount of $\geq 1$ to $\leq 99$ parts by weight based on 100 parts by weight of (A)+(B) in terms of solid content. Preferably, the photocurable monomer may be present in an amount of

$\geq$ 20 to $\leq$ 95 parts by weight, more preferably $\geq$ 30 to $\leq$ 95 parts by weight, still more preferably $\geq$ 60 to $\leq$ 95 parts by weight. Within this range, the photocurable composition may exhibit strong resistance to plasma, thereby lowering or preventing outgas generation from plasma or water vapor transmission rate in manufacture of thin encapsulation layers.

(B) <u>Silicon-containing monomer</u>

The silicon-containing monomer may be a silicon type monomer containing silicon and have photocurable functional groups, such as a (meth)acrylate group, a vinyl group, and the like.

The silicon-containing monomer may be represented by Formula 1:

[Formula 1]

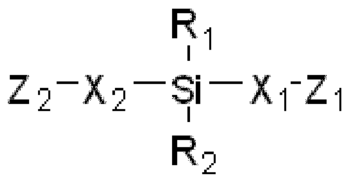

,

wherein $X_1$ and $X_2$ are each independently O, S, NH, or NR' (R' is a $C_1$ to $C_{10}$ alkyl group, a $C_3$ to $C_{10}$ cycloalkyl group, or a $C_6$ to $C_{10}$ aryl group);

$R_1$ and $R_2$ are each independently hydrogen, a substituted or unsubstituted $C_1$ to $C_{30}$ alkyl group, a substituted or unsubstituted $C_1$ to $C_{30}$ alkyl ether group, a monoalkyl amine or dialkyl amine group having a substituted or unsubstituted $C_1$ to $C_{30}$ alkyl group, a substituted or unsubstituted $C_1$ to $C_{30}$ thioalkyl group, a substituted or unsubstituted $C_6$ to $C_{30}$ aryl group, a substituted or unsubstituted $C_7$ to $C_{30}$ arylalkyl group, a substituted or unsubstituted $C_1$ to $C_{30}$ alkoxy group, or a substituted or unsubstituted $C_7$ to $C_{30}$ arylalkoxy group;

$Z_1$ and $Z_2$ are each independently hydrogen, or a group represented by Formula 2:

[Formula 2]

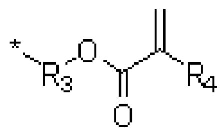

,

wherein * represents a binding site for $X_1$ or $X_2$ in Formula 1, $R_3$ is a substituted or unsubstituted $C_1$ to $C_{30}$ alkylene group, a substituted or unsubstituted $C_6$ to $C_{30}$ arylene group, or a substituted or unsubstituted $C_7$ to $C_{30}$ arylalkylene group, and $R_4$ is hydrogen, or a substituted or unsubstituted $C_1$ to $C_{30}$ alkyl group; and at least one of $Z_1$ and $Z_2$ is a group represented by Formula 2.

In one embodiment, the (B) silicon-containing monomer has a structure represented by Formula 1, wherein $X_1$ and $X_2$ are each independently O or S; $R_1$ and $R_2$ are each independently hydrogen, a substituted or unsubstituted $C_1$ to $C_{30}$ alkyl group, a substituted or unsubstituted $C_6$ to $C_{30}$ aryl group, or a substituted or unsubstituted $C_7$ to $C_{30}$ arylalkyl group; and $Z_1$ and $Z_2$ are each independently hydrogen, or a group represented by Formula 2:

[Formula 2]

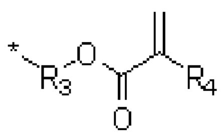

,

wherein * represents a binding site for $X_1$ or $X_2$ in Formula 1; $R_3$ is a substituted or unsubstituted $C_1$ to $C_{10}$ alkylene group; and $R_4$ is hydrogen, or a substituted or unsubstituted $C_1$ to $C_5$ alkyl group, and at least one of $Z_1$ and $Z_2$ is a group represented by Formula 2.

Preferably, $R_1$ and $R_2$ may be a $C_1$ to $C_{10}$ alkyl group, or a $C_6$ to $C_{20}$ aryl group, and more preferably a $C_1$ to $C_6$ alkyl group, or a $C_6$ to $C_{10}$ aryl group.

At least one of $Z_1$ and $Z_2$ may be a group represented by Formula 2 wherein $R_3$ is a $C_1$ to $C_{10}$ alkylene group.

The silicon-containing monomer may include at least one of the structures represented by Formula 3 and Formula 4:

<Formula 3>

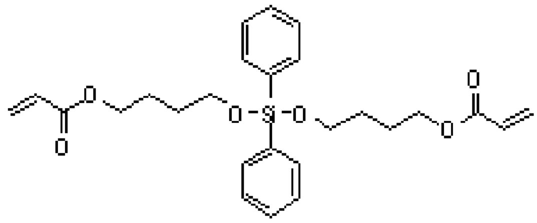

<Formula 4>

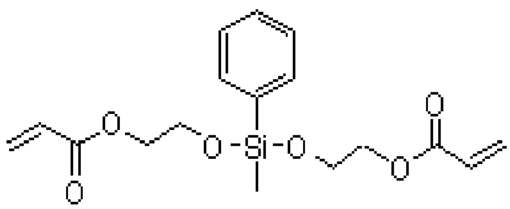

The silicon-containing monomer may be commercially available or synthesized by any typical method.

The silicon-containing monomer included in the photocurable composition together with the photocurable monomer can realize a layer, the water vapor transmission rate and outgas generation amount of which are remarkably reduced after curing, and can increase the photocuring rate. In addition, due to the presence of silicon, the silicon-containing monomer included in the organic barrier layer can minimize device damage by plasma used for deposition of an inorganic barrier layer in an existing encapsulation structure wherein the inorganic barrier layer and the organic barrier layer are deposited.

The silicon-containing monomer may be present in an amount of ≥ 1 part by weight to ≤ 99 parts by weight based on 100 parts by weight of (A)+(B). Preferably, the silicon-containing monomer may be present in an amount of ≥ 5 parts by weight to ≤ 80 parts by weight, more preferably ≥ 5 parts by weight to ≤ 70 parts by weight, still more preferably ≥ 5 parts by weight to ≤ 40 parts by weight. Within this range, the photocurable composition may exhibit strong resistance to plasma, thereby lowering or preventing outgas generation from plasma or water vapor transmission rate in preparation of thin encapsulation layers.

(C) <u>Photopolymerization initiator</u>

As the photopolymerization initiator, any typical photopolymerization initiator may be used without limitation. For example, the photopolymerization initiator may include triazine, acetophenone, benzophenone, thioxanthone, benzoin, phosphorus, oxime initiators, and mixtures thereof.

Examples of the triazine initiators may include 2,4,6-trichloro-s-triazine, 2-phenyl-4,6-bis(trichloromethyl)-s-triazine, 2-(3',4'-dimethoxystyryl)-4,6-bis(trichloro methyl)-s-triazine, 2-(4'-methoxynaphthyl)-4,6-bis(trichloromethyl)-s-triazine, 2-(p-methoxyphenyl)-4,6-bis(trichloromethyl)-s-triazine, 2-(p-tolyl)-4,6-bis(trichloromethyl)-s-triazine, 2-biphenyl-4,6-bis(trichloromethyl)-s-triazine, bis(trichloromethyl)-6-styryl-s-triazine, 2-(naphtho-1-yl)-4,6-bis(trichloromethyl)-s-triazine, 2-(4-methoxynaphtho-1-yl)-4,6-bis(trichloromethyl)-s-triazine, 2,4-trichloromethyl(piperonyl)-6-triazine, 2,4-(trichloro methyl(4'-methoxystyryl)-6-triazine, and mixtures thereof.

Examples of the acetophenone initiators may include 2,2'-diethoxy acetophenone, 2,2'-dibutoxyacetophenone, 2-hydroxy-2-methylpropiophenone, p-t-butyl trichloroacetophenone, p-t-butyl dichloroacetophenone, 4-chloroacetophenone, 2,2'-dichloro-4-phenoxyacetophenone, 2-methyl-1-(4-(methylthio)phenyl)-2-morpholino propan-1-one, 2-benzyl-2-dimethylamino-1-(4-morpholinophenyl)-butan-1-one, and mixtures thereof.

Examples of the benzophenone initiators may include benzophenone, benzoyl benzoic acid, benzoyl benzoic acid methyl benzophenone, 4-phenylbenzophenone, hydroxybenzophenone, acrylated benzophenone, 4,4'-bis(dimethylamino)benzophenone, 4,4'-dichlorobenzophenone, 3,3'-dimethyl-2-methoxy benzophenone, and mixtures thereof.

Examples of the thioxanthone initiators may include thioxanthone, 2-methylthioxanthone, isopropyl thioxanthone, 2,4-diethylthioxanthone, 2,4-diisopropyl thioxanthone, 2-chlorothioxanthone, and mixtures thereof.

Examples of the benzoin initiators may include benzoin, benzoin methyl ether, benzoin ethyl ether, benzoin isopropyl ether, benzoin isobutyl ether, benzyl dimethyl ketal, and mixtures thereof.

Examples of the phosphorus initiators may include bisbenzoylphenyl phosphine oxide, benzoyldiphenyl phosphine oxide, and mixtures thereof.

Examples of the oxime initiators may include 2-(o-benzoyloxime)-1-[4-(phenylthio)phenyl]-1,2-octanedione, 1-(o-acetyloxime)-1-[9-ethyl-6-(2-methylbenzoyl)-9H-carbazole-3-yl]ethanone, and mixtures thereof.

The photopolymerization initiator may be present in an amount of ≥ 0.1 parts by weight to ≤ 20 parts by weight based on 100 parts by weight of (A)+(B) in the photocurable composition. Within this range, photopolymerization can be sufficiently performed under exposure to light and reduction in transmission owing to unreacted initiator remaining after photopolymerization can be prevented. Preferably, the photopolymerization initiator may be present in an amount of ≥ 0.5 parts by weight to ≤ 10 parts by weight, more preferably ≥ 1 part by weight to ≤ 8 parts by weight.

The photocurable composition may include ≥ 50% by weight (wt%) to ≤ 95 wt% of (A), ≥ 1 wt% to ≤ 45 wt% of (B), and ≥ 0.1 wt% to ≤ 10 wt% of (C) in terms of solid content. Within this range, the organic barrier layer can exhibit low water vapor transmission rate, low outgas generation amount, and good adhesion. For example, the photocurable composition may include ≥ 55 wt% to ≤ 91 wt% of (A), ≥ 4 wt% to ≤ 40 wt% of (B), and ≥ 1 wt% to ≤ 5 wt% of (C).

The photocurable composition may exhibit a photocuring rate of ≥ 90%. Within this range, curing shrinkage stress after curing is low, thereby realizing layers not generating any shift, enabling use in encapsulation applications. For example, the photocuring rate may be ≥ 90 % to ≤ 99%, for example ≥ 91 % to ≤ 97%.

The photocuring rate may be measured by a typical method. For instance, the photocurable composition is coated onto a glass substrate and then subjected to curing at 100 $mW/cm^2$ for 10 seconds. The cured film is cut into specimens and the photocuring rate is measured on the specimens using FT-IR. The photocuring rate is calculated under the conditions that are disclosed in the following Examples.

The photocurable composition may be a composition for encapsulation of organic light emitting diodes.

A member for an apparatus, particularly a member for a display apparatus, may suffer degradation or deterioration in quality due to introduction of gas or liquid from a surrounding environment. For example, oxygen and/or moisture and/or water vapor in the atmosphere may penetrate chemical materials used in preparation of electronic products. To prevent this problem, the display apparatus is must be sealed or encapsulated, and the photocurable composition can be used for such sealing or encapsulation.

Examples of the member for the apparatus may include organic light emitting diodes (OLED), illumination devices, flexible organic light emitting diode displays, metal sensor pads, microdisc lasers, electrochromic devices, photochromic devices, microelectromechanical systems, solar cells, integrated circuits, charge coupled devices, light emitting polymers, light emitting diodes, and the like, without being limited thereto.

The photocurable composition satisfies properties such as adhesion to the inorganic barrier layer, photocuring rate, and the like, and thus, may be used for formation of organic barrier layers to be used in sealing or encapsulation for organic light emitting diodes, particularly, flexible display devices.

Another embodiment of the present invention relates to an encapsulated apparatus including a member for the apparatus and a barrier stack formed on the member for the apparatus and including an inorganic barrier layer and an organic barrier layer formed of the photocurable composition, wherein the organic barrier layer may have an outgas generation amount of ≤ 1,000 ppm.

A further embodiment of the present invention relates to an encapsulated apparatus including a member for the apparatus and a barrier stack formed on the member for the apparatus and including an inorganic barrier layer and an organic barrier layer formed of the photocurable composition, wherein the organic barrier layer may have a water vapor transmission rate of ≤ 5.0 $g/m^2 \cdot 24hr$, as measured at 37.8°C and 100% relative humidity (RH) for 24 hours at a layer thickness of the organic barrier layer of 5 μm.

Here, the encapsulated apparatus may include at least two layers of the inorganic barrier layers and the organic barrier layers.

The inorganic barrier layer differs from the organic barrier layer in terms of components, and may enhance the effects of the organic barrier layer.

The inorganic barrier layer is not particularly limited so long as the barrier layer exhibits good light transmittance and good moisture and/or oxygen barrier properties.

For example, the inorganic barrier layer may include metals, intermetallic compounds or alloys, oxides of metals or mixed metals, fluorides of metals or mixed metals, nitrides of metals or mixed metals, metal carbides, oxygen nitrides of metals or mixed metals, borides of metals or mixed metals, oxygen borides of metals or mixed metals, silicides of metals or mixed metals, and mixtures thereof.

In one embodiment, the metals may include silicon (Si), aluminium (Al), selenium (Se), zinc (Zn), antimony (Sb), indium (In), germanium (Ge), tin (Sn), bismuth (Bi), a transition metal, a lanthanide, and the like, without being limited thereto.

Particularly, the inorganic barrier layer may include silicon oxide, silicon nitride, silicon oxygen nitride, ZnSe,

$ZnO$, $Sb_2O_3$, $Al_2O_3$, $In_2O_3$, or $SnO_2$.

The inorganic barrier layer may be deposited by vacuum processes, for example, by sputtering, chemical vapor deposition, metal organic chemical vapor deposition, plasma chemical vapor deposition, evaporation, sublimation, electron cyclotron resonance-plasma enhanced chemical vapor deposition, or combinations thereof.

The inorganic barrier layer may have a thickness of ≥ 100 μm to ≤ 2,000 μm, respectively or totally, without being limited thereto.

The organic barrier layer exhibits little outgassing and minimizes the effects of outgassing on the devices, thereby preventing the devices from suffering performance degradation or decrease due to outgassing. Specifically, the organic barrier layer may have an outgas generation amount of ≤ 1,000 ppm. Within this range, the organic barrier layer has an insignificant effect when applied to the apparatus and ensures a very long lifespan of the devices. For example, the outgas generation amount may be ≥ 10 ppm to ≤ 1,000 ppm, for example ≥ 200 ppm to ≤ 870 ppm.

The outgas generation amount may be measured by typical methods. For example, the photocurable composition is coated onto a glass substrate and then subjected to UV curing by UV irradiation at 100 $mW/cm^2$ for 10 seconds to produce an organic barrier layer specimen having a size of 20 cm x 20 cm x 3 μm (width x length x thickness). For the specimen, the outgas generation amount is determined under the conditions prescribed in the following Examples.

The organic barrier layer may have a thickness of ≥ 0.1 μm to ≤ 10 μm, respectively or totally, without being limited thereto.

The organic barrier layer may have low water vapor transmission rate (WVTR) and thus can minimize the effect of moisture on the devices. The organic barrier layer may have a water vapor transmission rate of ≤ 5.0 $g/m^2 \cdot 24hr$ in a thickness direction thereof. Within this range, the organic barrier layer can be used to encapsulate the devices. For example, the organic barrier layer may have a water vapor transmission rate of ≥ 1.0 $g/m^2 \cdot 24hr$ to ≤ 4.9 $g/m^2 \cdot 24hr$, for example ≥ 2.0 $g/m^2 \cdot 24hr$ to ≤ 4.9 $g/m^2 \cdot 24hr$.

The water vapor transmission rate may be measured by typical methods. For example, a photocurable composition is coated onto an Al sample holder of a water vapor transmission rate tester (PERMATRAN-W 3/33, manufactured by MOCON) and subjected to UV curing by UV irradiation at 100 $mW/cm^2$ for 10 seconds to produce a cured specimen having a layer thickness of 5μm. A water vapor transmission rate is measured at 37.8°C and 100% RH for 24 hours at a layer thickness of 5 μm.

The organic barrier layer may have an adhesive strength to the inorganic barrier layer of ≥ 20 kgf. Within this range, adhesive strength between the organic barrier layer and the inorganic barrier layer is high, and thus, an encapsulation structure is maintained when physical impact is applied to devices employing the organic barrier layer, whereby the member for the apparatus can have a long lifespan. For example, the organic barrier layer has an adhesive strength of ≥ 20 kgf to ≤ 50 kgf.

When the organic barrier layer and the inorganic barrier layer are alternately deposited, smoothing properties of the inorganic barrier layer can be secured. In addition, the organic barrier layer can prevent a defect in the inorganic barrier layer from spreading other regions of the inorganic barrier layer.

The barrier stack may include the organic barrier layer and the inorganic barrier layer, although the number of barrier stacks is not limited. The combination of the barrier stacks may be modified depending on desired degree of resistance to permeation of oxygen and/or moisture and/or water vapor and/or chemical materials.

In the barrier stack, the organic barrier layer and the inorganic barrier layer may be alternately deposited. This is because such deposition provides a favorable effect on the organic barrier layer due to physical properties of the composition. For this reason, the organic barrier layer and inorganic barrier layer may supplement or reinforce the encapsulation effect on the member for the apparatus.

The inorganic barrier layer may be deposited by vacuum processes, for example, by sputtering, chemical vapor deposition, plasma chemical vapor deposition, evaporation, sublimation, electron cyclotron resonance-plasma enhanced chemical vapor deposition, or combinations thereof.

The organic barrier layer may be deposited by a method similar to that of inorganic barrier layer, or may be formed by coating and curing the photocurable composition.

The apparatus may include a substrate depending on the type of the member for the apparatus.

The substrate is not particularly limited so long as it allows the member for the apparatus to be stacked thereon. Examples of the substrate may include transparent glass, plastic sheets, silicone or metal substrates, and the like.

The organic barrier layer may be stacked on the inorganic barrier layer and include materials different from those included in the inorganic barrier layer. For this reason, the organic barrier layer may supplement or reinforce the function of the inorganic barrier layer on preventing the devices from contacting external oxygen or moisture.

A pair of the inorganic barrier layer and the organic barrier layer may be deposited plural times, for example, two times or more, in the apparatus. In one embodiment, the inorganic barrier layers and the organic barrier layers are deposited alternately such as in the order of inorganic barrier layer/organic barrier layer/inorganic barrier layer/organic barrier layer. Preferably, the inorganic barrier layers and the organic barrier layers may be deposited in a total of ≤ 10 layers (for example, in a total of ≥ 2 to ≤ 10 layers), more preferably in a total of ≤ 7 layers (for example, in a total of ≥

2 to ≤ 7 layers), in the apparatus.

Figs. 1 and 2 are a sectional view of each encapsulated apparatus according to embodiments of the present invention.

Referring to Fig. 1, an encapsulated apparatus 100 may include a substrate 10, a member for the apparatus 20 formed on the substrate 10, and a barrier stack 30 including an inorganic barrier layer 31 and an organic barrier layer 32, wherein the inorganic barrier layer 31 contacts the member for the apparatus 20.

Referring to Fig. 2, an encapsulated apparatus 200 may include a substrate 10, a member for the apparatus 20 formed on the substrate 10, and a barrier stack 30 including an inorganic barrier layer 31 and an organic barrier layer 32, wherein the inorganic barrier layer 31 can encapsulate an interior space 40 in which the member for the apparatus 20 is received.

Although each of the inorganic barrier layer and the organic barrier layer is illustrated as being formed in a single layer in Figs. 1 and 2, the inorganic barrier layer and the organic barrier layer may be deposited in multiple layers. In addition, the apparatus may further include a sealant and/or a substrate (not shown in Figs. 1 and 2) on a lateral side and/or an upper side of a composite barrier layer including the inorganic barrier layer and the organic barrier layer.

The apparatus may be produced by any typical method. Devices are deposited on the substrate and then the inorganic barrier layer is formed thereon. The photocurable composition is coated to a thickness of ≥ 1 μm to ≤ 5 μm by deposition, spin coating, slit coating, and the like, and light is irradiated thereto to form the organic barrier layer. The procedure of forming the inorganic barrier layer and the organic barrier layer may be repeated (preferably ≤ 10 times).

In one embodiment, examples of the encapsulated apparatus may include organic light emitting display devices including an organic light emitting diode, display devices including a liquid crystal display device, and the like, solar cells, and the like, without being limited thereto.

Now, the present invention will be described in more detail with reference to some examples. However, it should be noted that these examples are provided for illustration only and are not to be construed in any way as limiting the present invention.

**Preparative Example 1: Preparation of a monomer of Formula 3**

A 1,000 ml flask provided with a cooling tube and a stirrer was filled with 400 ml of dichloromethane, and then, 68.3 g of 4-hydroxybutyl acrylate (Aldrich) and 53 g of triethylamine were introduced thereto. While stirring the reaction liquid at 0°C, 60 g of diphenyl dichlorosilane was slowly added to the flask, followed by stirring at 25°C for four hours. After removing the dichloromethane through reduced pressure distillation, 103 g of a compound represented by Formula 3 was obtained through purification over a silica gel column. The obtained compound had a purity of 97% as measured by HPLC.

[Formula 3]

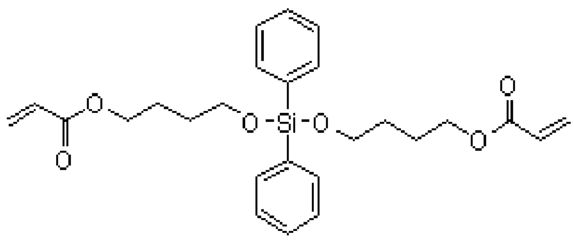

**Preparative Example 2: Preparation of a monomer of Formula 4**

A compound represented by Formula 4 was prepared in the same manner as in Preparative Example 1 except that phenyl methyl dichlorosilane was used instead of diphenyl dichlorosilane and 2-hydroxyethyl acrylate was used instead of 4-hydroxybutyl acrylate. As a result, 103 g of the compound represented by Formula 4 was obtained.

[Formula 4]

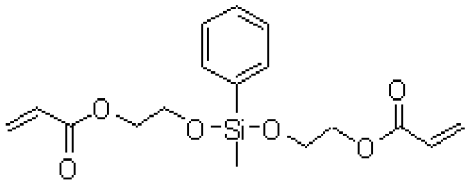

Details of components used in Examples and Comparative Examples were as follows:

(A) Photocurable monomer: (A1) Hexyl acrylate, (A2) Hexanediol diacrylate, (A3) Pentaerythritol tetraacrylate (Aldrich)
(B) Silicon-containing monomer: (B1) Monomer prepared in Preparative Example 1, (B2) Monomer prepared in Preparative Example 2.
(C) Photopolymerization initiator: Darocur® TPO (BASF)

**Examples 1 to 8 and Comparative Examples 1 to 3**

The (A) photocurable monomer, the (B) silicon-containing monomer and the (C) photopolymerization initiator were placed in amounts as listed in Table 2 (unit: parts by weight) to a 125 ml brown polypropylene bottle, followed by blending using a shaker for 3 hours to prepare compositions.

The compositions produced in the Examples and Comparative Examples were evaluated as to physical properties. Results are shown in Table 2.

1. Water vapor transmission rate: A water vapor transmission rate tester (PERMATRAN-W 3/33, manufactured by MOCON) was employed. The photocurable composition was spray-coated onto an Al sample holder and subjected to UV curing by UV irradiation at 100 mW/cm$^2$ for 10 seconds to produce a cured specimen having a layer thickness of 5μm. Water vapor transmission rate was measured using the water vapor transmission rate tester (PERMATRAN-W 3/33, manufactured by MOCON) at 37.8°C and 100% RH for 24 hours at a layer thickness of 5 μm.

2. Outgas generation amount: The photocurable composition was spray-coated onto a glass substrate and subjected to UV curing by UV irradiation at 100 mW/cm$^2$ for 10 seconds to produce an organic barrier layer specimen having a size of 20 cm x 20 cm x 3 μm (width x length x thickness). A GC/MS tester (Perkin Elmer Clarus 600) was used to measure outgas generation. GC/MS utilized a DB-5MS column (length: 30 m, diameter: 0.25 mm, thickness of fixed phase: 0.25 μm) as a column, and helium gas (flow rate: 1.0 mL/min, average velocity = 32 cm/s) as a mobile phase. Further, the split ratio was 20:1 and the temperature condition was set such that temperature was maintained at 40°C for 3 minutes, heated at a rate of 10°C/minute, and then maintained at 320°C for 6 minutes. Outgas was collected under the conditions that a glass size was 20 cm x 20 cm, the collection container was a Tedlar® bag, the collection temperature was 90°C, the collection time was 30 minutes, $N_2$ purging was conducted at a flow rate of 300 mL/minute and the adsorbent was Tenax® GR (5% phenylmethyl polysiloxane). A calibration curve was plotted using a toluene solution in n-hexane in a concentration of 150 ppm, 400 ppm and 800 ppm as a standard solution, wherein R2 value was 0.9987. The conditions mentioned above are summarized in Table 1.

Table 1

| Conditions | Details |
|---|---|
| Collection conditions | - Glass size: 20cm x 20cm<br>- Collection container: Tedlar® bag<br>- Collection temperature: 90°C<br>- Collection time: 30 min<br>- $N_2$ purge flow rate: 300 mL/min<br>- Adsorbent: Tenax® GR |
| Conditions for plotting calibration curve | - Standard solution: Toluene in n-hexane<br>- Concentration range: 150 ppm, 400 ppm, 800 ppm<br>- R2: 0.9987 |

(continued)

| Conditions | Details | | | |
|---|---|---|---|---|
| GC/MS conditions | | Column | DB-5MS→30 m x 0.25mm x 0.25μm (5% phenylmethyl polysiloxane) | |
| | | Mobile phase | He | |
| | | Flow | 1.0 mL/min (Average velocity = 32 cm/s) | |
| | | Split | Split ratio = 20:1 | |
| | | Method | 40°C (3 min) - 10°C /min→ 320°C (6 min) | |

3. Photocuring rate: The intensity of absorption peaks for the photocurable composition were measured using FT-IR (NICOLET 4700, Thermo) near 1635 $cm^{-1}$ (C=C) and 1720 $cm^{-1}$ (C=O). First, the photocurable composition was spray-coated onto a glass substrate and then subjected to UV curing by UV irradiation at 100 $mW/cm^2$ for 10 seconds to produce a specimen having a size of 20 cm x 20 cm x 3μm (width x length x thickness). The cured film was cut into specimens, which in turn were used to measure the intensity of absorption peaks near 1635 $cm^{-1}$ (C=C) and 1720 $cm^{-1}$ (C=O) using FT-IR (NICOLET 4700, by Thermo). The photocuring rate was calculated by Equation 1:

[Equation 1]

$$\text{Photocuring rate (\%)} = |\, 1-(A/B)\, | \times 100,$$

wherein A is a ratio of the intensity of absorption peak near 1635 $cm^{-1}$ to the intensity of absorption peak near 1720 $cm^{-1}$ on the cured film, and B is a ratio of the intensity of absorption peak near 1635 $cm^{-1}$ to the intensity of absorption peak near 1720 $cm^{-1}$ on the photocurable composition.

4. Adhesive strength (kgf): To measure an adhesive strength between glass sheets, the same method as a method for measuring die shear strength was used. An upper glass was pushed from a lateral side by a force of 200 kgf at 25°C, and a force at the moment of detachment thereof was measured using a Dage Series 4000PXY, which is an adhesive strength tester. A lower glass had a size of 2 cm x 2 cm x 1 mm(width x length x thickness), the upper glass had a size of 1.5 cm x 1.5 cm x 1 mm(width x length x thickness), and an adhesive layer had a thickness of 500 μm.

Table 2

| | | Example | | | | | | | | Comparative Example | | |
|---|---|---|---|---|---|---|---|---|---|---|---|---|
| | | 1 | 2 | 3 | 4 | 5 | 6 | 7 | 8 | 1 | 2 | 3 |
| A | A1 | 20 | 20 | 20 | 20 | 20 | 20 | 20 | 20 | 20 | 20 | 20 |
| | A2 | 40 | 60 | 70 | 70 | 40 | 60 | 70 | 70 | 40 | 60 | 70 |
| | A3 | - | - | - | 5 | - | - | - | 5 | 40 | 20 | 10 |
| B | B1 | 40 | 20 | 10 | 5 | - | - | - | - | - | - | - |
| | B2 | - | - | - | - | 40 | 20 | 10 | 5 | - | - | - |
| C | 5 | 5 | 5 | 5 | 5 | 5 | 5 | 5 | 5 | 5 | 5 | |
| Water vapor transmission rate ($g/m^2\cdot 24hr$) | 2.0 | 2.7 | 3.5 | 4.9 | 2.3 | 3.1 | 3.5 | 4.1 | 6.8 | 7.7 | 9.4 | |
| Outgas generation amount (ppm) | 230 | 250 | 380 | 870 | 210 | 230 | 280 | 340 | 13200 | 1510 | 2780 | |
| Photocuring rate (%) | 96.1 | 93.4 | 92.1 | 91.5 | 96.3 | 96.0 | 95.2 | 94.5 | 83 | 87.5 | 89.2 | |

(continued)

| | | Example | | | | | | | | Comparative Example | | |
|---|---|---|---|---|---|---|---|---|---|---|---|---|
| | | 1 | 2 | 3 | 4 | 5 | 6 | 7 | 8 | 1 | 2 | 3 |
| Adhesive strength (kgf) | 38.1 | 33.3 | 23.8 | 21.2 | 42.5 | 36.5 | 29.1 | 26.3 | 14.8 | 13.5 | 11.5 | |

As shown in Table 2, the layers formed of the photocurable compositions according to Examples demonstrated low water vapor transmission rate, significantly reduced outgas generation amount, a significantly high photocuring rate, and a high adhesive strength.

On the contrary, the layers formed of the photocurable compositions according to Comparative Examples 1 to 3 which do not include a silicon-containing monomer demonstrated high water vapor transmission rate, high outgas generation amount, a low photocuring rate, and a low adhesive strength, thereby preventing the layers from realizing the effects of the present invention.

Although some embodiments have been described, it will be apparent to those skilled in the art that these embodiments are given by way of illustration only, and that various modifications, changes, alterations, and equivalent embodiments can be made without departing from the spirit and scope of the invention. The scope of the invention should be limited only by the accompanying claims and equivalents thereof.

## Claims

**1.** A photocurable composition comprising:

(A) a photocurable monomer;
(B) a silicon-containing monomer; and
(C) a photopolymerization initiator,
wherein the (B) silicon-containing monomer has a structure represented Formula 1:

[Formula 1]

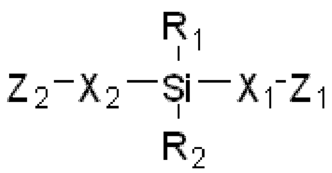

,

wherein $X_1$ and $X_2$ are each independently O, S, NH, or NR' (R' is a $C_1$ to $C_{10}$ alkyl group, a $C_3$ to $C_{10}$ cycloalkyl group, or a $C_6$ to C10 aryl group);
$R_1$ and $R_2$ are each independently hydrogen, a substituted or unsubstituted $C_1$ to $C_{30}$ alkyl group, a substituted or unsubstituted $C_1$ to $C_{30}$ alkyl ether group, a monoalkyl amine or dialkyl amine group having a substituted or unsubstituted $C_1$ to $C_{30}$ alkyl group, a substituted or unsubstituted $C_1$ to $C_{30}$ thioalkyl group, a substituted or unsubstituted $C_6$ to $C_{30}$ aryl group, a substituted or unsubstituted $C_7$ to $C_{30}$ arylalkyl group, a substituted or unsubstituted $C_1$ to $C_{30}$ alkoxy group, or a substituted or unsubstituted $C_7$ to $C_{30}$ arylalkoxy group;
$Z_1$ and $Z_2$ are each independently hydrogen, or a group represented by Formula 2:

[Formula 2]

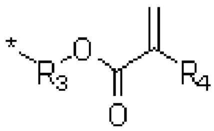

,

wherein * represents a binding site for $X_1$ or $X_2$ in Formula 1, $R_3$ is a substituted or unsubstituted $C_1$ to $C_{30}$ alkylene group, a substituted or unsubstituted $C_6$ to $C_{30}$ arylene group, or a substituted or unsubstituted $C_7$ to $C_{30}$ arylalkylene group, and $R_4$ is hydrogen, or a substituted or unsubstituted C1 to $C_{30}$ alkyl group; and at least one of $Z_1$ and $Z_2$ is a group represented by Formula 2.

**2.** The photocurable composition according to claim 1, wherein the (B) silicon-containing monomer has a structure represented by Formula 1, wherein $X_1$ and $X_2$ are each independently O or S; $R_1$ and $R_2$ are each independently hydrogen, a substituted or unsubstituted $C_1$ to $C_{30}$ alkyl group, a substituted or unsubstituted $C_6$ to $C_{30}$ aryl group, or a substituted or unsubstituted $C_7$ to $C_{30}$ arylalkyl group; and $Z_1$ and $Z_2$ are each independently hydrogen, or a group represented by Formula 2:

[Formula 2]

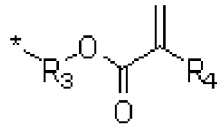

,

wherein * represents a binding site for $X_1$ or $X_2$ in Formula 1; $R_3$ is a substituted or unsubstituted $C_1$ to $C_{10}$ alkylene group; and $R_4$ is hydrogen, or a substituted or unsubstituted $C_1$ to $C_5$ alkyl group, and at least one of $Z_1$ and $Z_2$ is a group represented by Formula 2.

**3.** The photocurable composition according to claim 1 or 2, wherein the (B) silicon-containing monomer comprises at least one of monomers represented by Formula 3 and Formula 4:

<Formula 3>

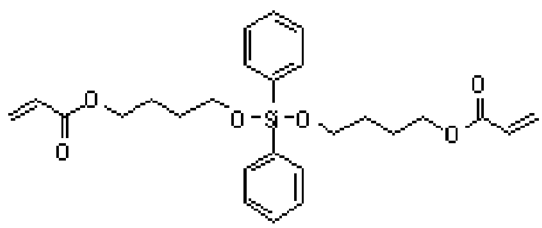

<Formula 4>

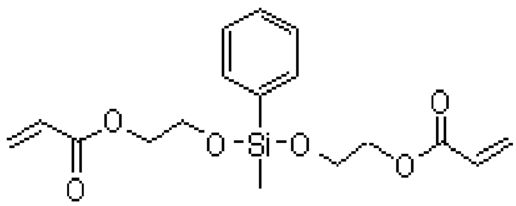

**4.** The photocurable composition according to claims 1 to 3, wherein the (A) photocurable monomer comprises a monomer having ≥ 1 to ≤ 30 substituted or unsubstituted vinyl groups, a monomer having ≥ 1 to ≤ 30 substituted or unsubstituted acrylate groups, or a monomer having ≥ 1 to ≤ 30 substituted or unsubstituted methacrylate groups.

**5.** The photocurable composition according to claims 1 to 4, wherein the photocurable monomer is present in an amount of ≥ 1 to ≤ 99 parts by weight, the silicon-containing monomer is present in an amount of ≥ 1 part by weight to ≤ 99 parts by weight, and the photopolymerization initiator is present in an amount of ≥ 0.1 parts by weight to ≤ 20 parts by weight based on 100 parts by weight of (A)+(B) in the photocurable composition.

**6.** A composition for encapsulation of organic light emitting devices comprising the photocurable composition according to any one of claims 1 to 5.

**7.** An encapsulated device encapsulated with the photocurable composition according to any one of claims 1 to 5.

**8.** An encapsulated apparatus comprising:

a member for the apparatus; and
a barrier stack formed on the member for the apparatus and comprising an inorganic barrier layer and an organic barrier layer formed from the photocurable composition according to claims 1 to 5,
wherein the organic barrier layer has an outgas generation amount of ≤ 1,000 ppm.

**9.** An encapsulated apparatus comprising:

a member for the apparatus; and
a barrier stack formed on the member for the apparatus and including an inorganic barrier layer and an organic barrier layer formed from the photocurable composition according to claims 1 to 5,
wherein the organic barrier layer has a water vapor transmission rate of ≤ 5.0 $g/m^2 \cdot 24hr$, as measured at 37.8°C and 100% relative humidity (RH) for 24 hours at a layer thickness of the organic barrier layer of 5 μm.

**10.** The encapsulated apparatus according to claim 8 or 9, wherein the inorganic barrier layer and the organic barrier layer are deposited at least two layers.

**11.** The encapsulated apparatus according to claims 8 to 10, wherein the inorganic barrier layer comprises metal, metal oxides, metal nitrides, metal carbides, metal oxygen nitrides, metal oxygen borides, and mixtures thereof, and wherein the metal comprises at least one selected from the group consisting of silicon (Si), aluminium (Al), selenium (Se), zinc (Zn), antimony (Sb), indium (In), germanium (Ge), tin (Sn), bismuth (Bi), a transition metal, and a lanthanide metal.

**12.** The encapsulated apparatus according to claims 8 to 11, wherein each of the organic barrier layer has a thickness of ≥ 0.1 μm to ≤ 10 μm, and each of the inorganic barrier layer has a thickness of ≥ 100 μm to ≤ 2,000 μm.

**13.** The encapsulated apparatus according to claims 8 to 12, wherein the member for the apparatus comprises flexible organic light emitting devices, organic light emitting devices, illumination devices, metal sensor pads, microdisc lasers, electrochromic devices, photochromic devices, microelectromechanical systems, solar cells, integrated circuits, charge coupled devices, light emitting polymers, or light emitting diodes.

Fig 1.

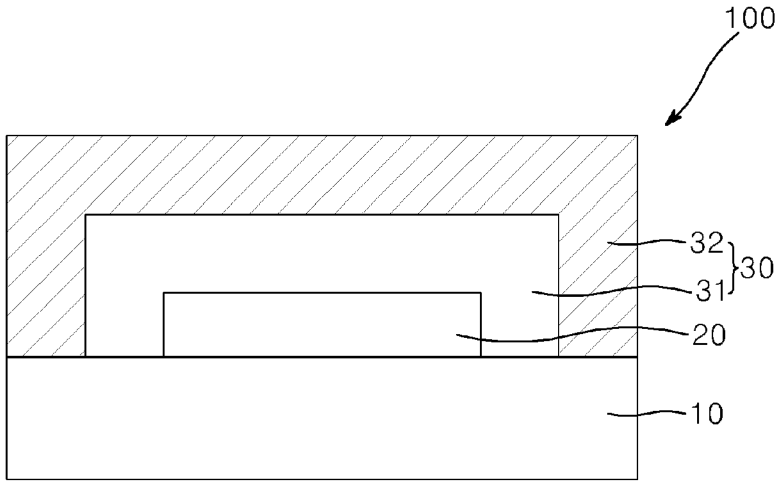


Fig. 2

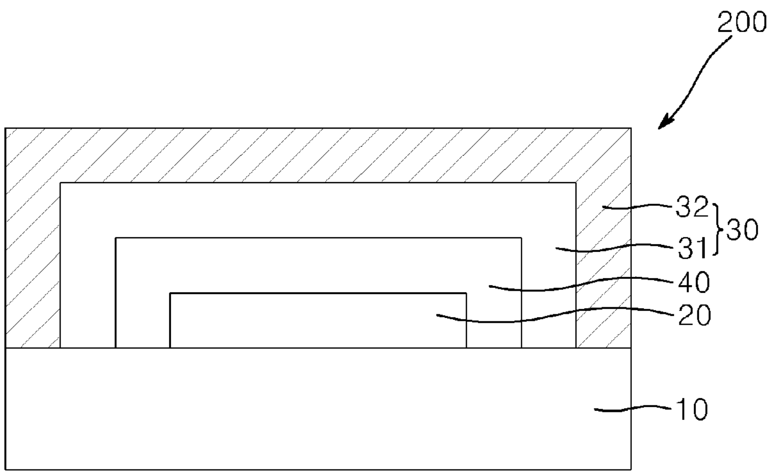

Europäisches Patentamt
European Patent Office
Office européen des brevets

# EUROPEAN SEARCH REPORT

Application Number
EP 13 17 8450

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | EP 1 502 922 A1 (LOCTITE R & D LTD [IE]) 2 February 2005 (2005-02-02) * paragraph [0048]; claims 1-25 * ----- | 1-13 | INV. G03F7/027 G03F7/075 |
| A | EP 2 412 746 A1 (CHEIL IND INC [KR]) 1 February 2012 (2012-02-01) * paragraph [0055]; claims 1-12 * ----- | 1-13 | |
| A | LIN A W ET AL: "Encapsulant for non-hermetic multichip packaging applications", 1991 PROCEEDINGS / 41ST ELECTRONIC COMPONENTS & TECHNOLOGY CONFERENCE, MAY 11 - 16, 1991, ATLANTA, GEORGIA, IEEE, NEW YORK, US, 11 May 1991 (1991-05-11), pages 820-826, XP010044464, DOI: 10.1109/ECTC.1991.163974 ISBN: 978-0-7803-0012-5 * page 820 - page 826 * ----- | 1-13 | |
| | | | TECHNICAL FIELDS SEARCHED (IPC) |
| A | WO 2005/040294 A1 (DEGUSSA [DE]; REMBRANDTIN LACK GMBH [AT]; EDELMANN ROLAND [DE]; MONKIE) 6 May 2005 (2005-05-06) * page 3; claims 1-24 * ----- | 1-13 | G03F |

The present search report has been drawn up for all claims

| Place of search | Date of completion of the search | Examiner |
|---|---|---|
| Munich | 15 October 2013 | Oechsner de Coninck |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

2

EPO FORM 1503 03.82 (P04C01)

## ANNEX TO THE EUROPEAN SEARCH REPORT ON EUROPEAN PATENT APPLICATION NO. EP 13 17 8450

This annex lists the patent family members relating to the patent documents cited in the above-mentioned European search report.
The members are as contained in the European Patent Office EDP file on
The European Patent Office is in no way liable for these particulars which are merely given for the purpose of information.

15-10-2013

| Patent document cited in search report | Publication date | Patent family member(s) | Publication date |
|---|---|---|---|
| EP 1502922 A1 | 02-02-2005 | EP 1502922 A1 | 02-02-2005 |
| | | JP 2005163010 A | 23-06-2005 |
| | | KR 20050014707 A | 07-02-2005 |
| | | US 2005023665 A1 | 03-02-2005 |
| EP 2412746 A1 | 01-02-2012 | EP 2412746 A1 | 01-02-2012 |
| | | KR 20120011827 A | 08-02-2012 |
| | | TW 201211114 A | 16-03-2012 |
| | | US 2012029157 A1 | 02-02-2012 |
| WO 2005040294 A1 | 06-05-2005 | AT 538187 T | 15-01-2012 |
| | | CN 1894353 A | 10-01-2007 |
| | | DE 10362060 A1 | 15-09-2005 |
| | | EP 1678267 A1 | 12-07-2006 |
| | | JP 2007513212 A | 24-05-2007 |
| | | US 2007099004 A1 | 03-05-2007 |
| | | WO 2005040294 A1 | 06-05-2005 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- KR 20060084978 A